(19) Europäisches Patentamt / European Patent Office / Office européen des brevets

(11) **EP 4 749 625 A1**

(12) **DEMANDE DE BREVET EUROPEEN**

(43) Date de publication:
**27.05.2026 Bulletin 2026/22**

(21) Numéro de dépôt: **25218265.4**

(22) Date de dépôt: **25.11.2025**

(51) Classification Internationale des Brevets (IPC):
**G11C 11/54** (2006.01) **G06N 3/065** (2023.01)

(52) Classification Coopérative des Brevets (CPC):
**G11C 11/54; G06N 3/065; G06N 7/01**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **26.11.2024 FR 2412984**

(71) Demandeurs:
• **Commissariat à l'Energie Atomique et aux Energies Alternatives**
**75015 Paris (FR)**
• **Centre National de la Recherche Scientifique**
**75016 Paris (FR)**
• **Université d'Aix Marseille**
**13007 Marseille (FR)**

(72) Inventeurs:
• **JANUEL, Tarcisius**
**38054 GRENOBLE CEDEX 9 (FR)**
• **VIANELLO, Elisa**
**38054 GRENOBLE CEDEX 9 (FR)**
• **BILLOINT, Olivier**
**38054 GRENOBLE CEDEX 9 (FR)**
• **PORTAL, Jean-Michel**
**13285 MARSEILLE CEDEX 07 (FR)**

(74) Mandataire: **Lavoix**
**2, place d'Estienne d'Orves**
**75441 Paris Cedex 09 (FR)**

(54) **CIRCUIT ÉLECTRONIQUE POUR LA MISE EN ŒUVRE D'UN RÉSEAU NEURONAL BAYÉSIEN**

(57) L'invention concerne un circuit électronique (10) pour la mise en œuvre d'un réseau neuronal bayésien, comprenant des lignes de bit, de source et de mot ; et
- au moins une branche primaire (15), chacune comportant une cellule primaire (30) connectée entre des lignes de source et de bit et incluant un composant mémoire primaire (32) et un commutateur primaire (34) connectés en série,
- au moins une branche secondaire (20), chacune comportant une cellule secondaire (50) connectée entre des lignes de source et de bit et incluant un composant mémoire secondaire (52) et un commutateur secondaire (54) connectés entre eux,
- un dispositif d'accumulation (25) configuré pour accumuler une quantité totale étant la somme d'une quantité primaire de charges issues d'une cellule primaire et d'une quantité secondaire de charges issues d'une cellule secondaire, les quantités primaire et secondaire étant accumulées indépendamment l'une de l'autre.

FIG.1

EP 4 749 625 A1

**Description**

La présente invention concerne un circuit électronique pour la mise en œuvre d'un réseau neuronal bayésien.

L'invention concerne alors le domaine des circuits électroniques adaptés pour la mise en œuvre, notamment l'inférence, de réseaux neuronaux, en particulier de réseaux neuronaux bayésiens.

Les réseaux bayésiens sont particulièrement adaptés pour des applications de sécurité, telles que les soins de santé ou la conduite automobile autonome. L'un des atouts de ces réseaux est de quantifier l'incertitude des résultats en fonction des données d'entrée. Dans l'exemple d'un classificateur, une fois l'apprentissage effectué, la dispersion des résultats permet d'identifier deux types d'incertitude : soit la classification n'est pas claire (données bruitées ou les entrées correspondent aux caractéristiques de plusieurs classes en même temps), soit la classification est inconnue.

Les réseaux neuronaux sont généralement classés en deux familles : les réseaux neuronaux déterministes, qui fournissent une sortie déterministe pour une entrée donnée ; et les réseaux neuronaux bayésiens, également appelés réseaux neuronaux probabilistes, qui sont basés sur des modèles d'apprentissage profond bayésiens et qui codent des paramètres synaptiques, notamment des poids synaptiques, à l'aide de distributions de probabilités.

Dans les réseaux neuronaux déterministes, les poids sont des nombres réels, et la sortie de chaque neurone est la somme pondérée de ses entrées, à laquelle une fonction d'activation est ensuite appliquée.

Au lieu de choisir des poids fixes pour l'apprentissage, les neurones bayésiens échantillonnent leurs poids dans des distributions. Plutôt que d'utiliser une distribution quelconque, les distributions gaussiennes (ou normales) ont l'avantage de simplifier la formulation et l'évaluation d'un modèle bayésien en utilisant les propriétés des variables aléatoires gaussiennes.

Pour générer une distribution gaussienne, une première approche est de générer cette distribution à partir d'une multitude de composants mémoire, telles que des mémoires vives résistives à base d'oxyde, aussi appelées OxRAM (de l'anglais *Oxyde-based Random-Access Memory*). Chaque échantillon de la gaussienne est alors obtenu en programmant un composant mémoire respectif. Cette première approche est par exemple décrite dans l'article « In situ learning using intrinsic memristor variability via Markov chain Monte Carlo sampling » de Dalgaty et al., publié dans Nature electronics en 2021, ainsi que dans l'article « Bringing uncertainty quantification to the extreme-edge with memristor-based Bayesian neural networks » de Bonnet et al., publié dans Nature communication en 2023.

Toutefois, selon cette première approche, l'implémentation matérielle du réseau neuronal bayésien engendre un circuit électronique de surface importante puisqu'il faut une mémoire par échantillon de la distribution gaussienne.

Une deuxième approche pour générer la distribution gaussienne est de stocker les propriétés principales de la distribution gaussienne, à savoir sa valeur moyenne et son écart-type, dans des composants mémoire, puis d'effectuer des opérations de lecture avec ces composants pour générer des valeurs aléatoires représentatives de cette distribution gaussienne.

Selon cette deuxième approche, le document EP 4 174 724 B1 décrit un circuit synapse pour un réseau neuronal bayésien, le circuit comprenant un premier dispositif de mémoire résistive couplant un premier rail de tension à une première borne d'un condensateur, la première borne du condensateur étant couplée à un deuxième rail de tension via une conductance variable ; et un deuxième dispositif de mémoire résistive couplant un troisième rail de tension à une première ligne de sortie du circuit synapse, une deuxième borne du condensateur étant couplée à une borne du deuxième dispositif de mémoire résistive.

Pour la génération d'une valeur aléatoire de la distribution gaussienne, sous forme d'un signal de courant sur une ligne de sortie du circuit synapse, ce document décrit alors de programmer le premier dispositif de mémoire résistive pour avoir un premier niveau de conductance ; de programmer le deuxième dispositif de mémoire résistive pour qu'il ait un deuxième niveau de conductance ; et d'appliquer une tension au premier rail de tension afin de générer un signal de courant sur la ligne de sortie.

Toutefois, avec un tel circuit synapse, le condensateur entre le premier dispositif de mémoire résistive et le deuxième dispositif de mémoire résistive engendre une certaine corrélation entre des deux dispositifs, et ce faisant une dépendance problématique entre la valeur moyenne et l'écart-type de la distribution générée. Par ailleurs, le document EP 4 174 724 B1 propose d'exploiter le bruit thermique du premier dispositif de mémoire résistif comme source de variabilité principale, mais ne prévoit pas de solution dans le cas où ce même dispositif mémoire est sujet au bruit télégraphique aléatoire.

Le but de l'invention vise à proposer un circuit électronique permettant de générer une distribution gaussienne avec un meilleur contrôle pour la mise en œuvre d'un réseau neuronal bayésien, tout en gardant des dimensions restreintes.

A cet effet, l'invention a pour objet un circuit électronique pour la mise en œuvre d'un réseau neuronal bayésien, comprenant :

- des lignes de bit ;
- des lignes de source ;

- au moins une ligne de mot ;
- au moins une branche primaire, la ou chaque branche primaire comportant au moins une cellule primaire connectée entre une ligne de source et une ligne de bit respectives, la ou chaque cellule primaire incluant un composant mémoire primaire et un commutateur primaire connectés en série, le commutateur primaire ayant une électrode de commande connectée à une ligne de mot respective,
- au moins une branche secondaire, la ou chaque branche secondaire comportant au moins une cellule secondaire connectée entre une ligne de source et une ligne de bit respectives, la ou chaque cellule secondaire incluant un composant mémoire secondaire et un commutateur secondaire connectés entre eux,

les lignes de source et de bit associées à la ou chaque branche secondaire étant distinctes des lignes de source et de bit associées à la ou chaque branche primaire,

- un dispositif d'accumulation connecté aux branches primaire(s) et secondaire(s) et configuré pour accumuler une quantité totale de charges électriques issues d'une paire respective de cellules, la paire étant formée d'une cellule primaire respective et d'une cellule secondaire respective, la quantité totale étant la somme d'une quantité primaire de charges issues de ladite cellule primaire et d'une quantité secondaire de charges issues de ladite cellule secondaire, la quantité primaire et la quantité secondaire étant accumulées indépendamment l'une de l'autre.

Avec le circuit électronique selon l'invention, chaque écart-type de distribution gaussienne est stocké dans une cellule primaire respective et chaque valeur moyenne de distribution gaussienne est stockée dans une cellule secondaire respective, et l'accumulation de la quantité primaire et de la quantité secondaire indépendamment l'une de l'autre permet alors de diminuer une corrélation entre la valeur moyenne et l'écart-type de la distribution générée, chaque valeur aléatoire de la distribution gaussienne générée étant obtenue à partir d'une valeur respective de la quantité totale accumulée. Une accumulation de charges indépendante entre lesdites branches primaire et secondaire permet de définir des temps d'intégration différents pour chacune des branches. Il s'agit d'un paramètre de conception supplémentaire pour contrôler la corrélation entre les branches.

A cet effet également, chaque cellule primaire est incluse dans une branche primaire correspondante, et chaque cellule secondaire est incluse dans une branche secondaire correspondante, la ou chaque branche secondaire étant distincte de la ou chaque branche primaire et agencée en parallèle de celle(s)-ci.

Lors d'une opération d'échantillonnage pour obtenir plusieurs échantillons de la distribution gaussienne, chaque échantillon résulte par exemple d'une valeur d'une tension de sortie du dispositif d'accumulation, cette tension de sortie dépendant de la quantité totale accumulée.

Préférentiellement, chaque composant mémoire primaire, secondaire comporte une mémoire résistive à base d'oxyde, ou OxRAM, ce qui permet alors de tirer parti de la variabilité de lecture à lecture de l'OxRAM pour l'opération d'échantillonnage.

Suivant d'autres aspects avantageux de l'invention, le circuit électronique comprend une ou plusieurs des caractéristiques suivantes, prises isolément ou suivant toutes les combinaisons techniquement possibles :

- la quantité primaire est accumulée au cours de deux phases successives : une phase de charge avec une première valeur de tension appliquée à la ligne de source correspondante, et une phase de décharge avec une deuxième valeur de tension appliquée à ladite ligne de source, la deuxième valeur étant distincte de la première valeur ;
- la ou chaque branche primaire comporte en outre un convertisseur tension-courant de la cellule primaire, le convertisseur tension-courant étant connecté entre un potentiel additionnel et le dispositif d'accumulation, le convertisseur tension-courant ayant une électrode de commande reliée à la cellule primaire via la ligne de bit correspondante ;
- le potentiel additionnel présente une valeur supérieure à un potentiel de référence en entrée du dispositif d'accumulation lors de la phase de charge, et une valeur inférieure au potentiel de référence en entrée du dispositif d'accumulation lors de la phase de décharge ;
- la ou chaque branche primaire comporte en outre une conductance variable, connectée entre un potentiel de référence et l'électrode de commande du convertisseur tension-courant ;
- la ou chaque branche primaire comporte en outre un condensateur ayant une borne connectée à l'électrode de commande du convertisseur tension-courant et l'autre borne à un potentiel de référence ;

la ou chaque branche primaire comportant de préférence un commutateur auxiliaire connecté entre la borne du condensateur qui connectée à ladite électrode de commande et un potentiel de pré-charge du condensateur ;

- le circuit électronique comporte en outre un cascode, dit cascode primaire, connecté entre la ou chaque branche primaire et le dispositif d'accumulation ;

**EP 4 749 625 A1**

- le ou chaque composant mémoire primaire est une mémoire sensible au bruit télégraphique aléatoire ;

le ou chaque composant mémoire primaire étant de préférence une mémoire choisie parmi le groupe consistant en : une mémoire résistive à base d'oxyde ; une mémoire vive à pontage conducteur ; une mémoire vive à changement de phase ; une mémoire vive magnétique ; et une mémoire à empilement ferroélectrique, telle qu'une mémoire ferroélectrique à jonction tunnel ;

- le ou chaque composant mémoire secondaire est une mémoire choisie parmi le groupe consistant en : une mémoire vive résistive à base d'oxyde ; une mémoire vive à pontage conducteur ; une mémoire vive à changement de phase ; une mémoire vive magnétique ; et une mémoire à empilement ferroélectrique telle qu'une capacité ferroélectrique ou une mémoire ferroélectrique à jonction tunnel ;
- le composant mémoire secondaire et le commutateur secondaire sont connectés en série entre la ligne de source et la ligne de bit respectives, le commutateur secondaire ayant une électrode de commande connectée à une ligne de mot respective ;
- le ou chaque composant mémoire secondaire est un composant choisi parmi le groupe consistant en : un transistor à effet de champ à mémoire ferroélectrique ; et un transistor à effet de champ ferroélectrique ;
- le composant mémoire secondaire est connecté entre la ligne de source et la ligne de bit respectives, et le commutateur secondaire est connecté entre une ligne de mot et une électrode de commande du composant mémoire secondaire ;
- le circuit électronique comporte en outre un cascode, dit cascode secondaire, connecté entre la ou chaque branche secondaire et le dispositif d'accumulation ;
- le dispositif d'accumulation comporte au moins un amplificateur à transimpédance ;
- le circuit électronique comprend N branches primaires et N branches secondaires agencées en N paires de branches primaire et secondaire, et le dispositif d'accumulation comporte N amplificateurs à transimpédance, chacun étant connecté à une paire respective de branches primaire et secondaire, N étant un nombre entier supérieur ou égal à 2 ;
- le circuit électronique comprend N branches secondaires, N étant un nombre entier supérieur ou égal à 2 ;
- le circuit électronique comprend une seule branche primaire ;
- le circuit électronique comprend N branches primaires ; et
- le dispositif d'accumulation comporte un seul amplificateur à transimpédance capacitive.

Ces caractéristiques et avantages de l'invention apparaîtront plus clairement à la lecture de la description qui va suivre, donnée uniquement à titre d'exemple non limitatif, et faite en référence aux dessins annexés, sur lesquels :

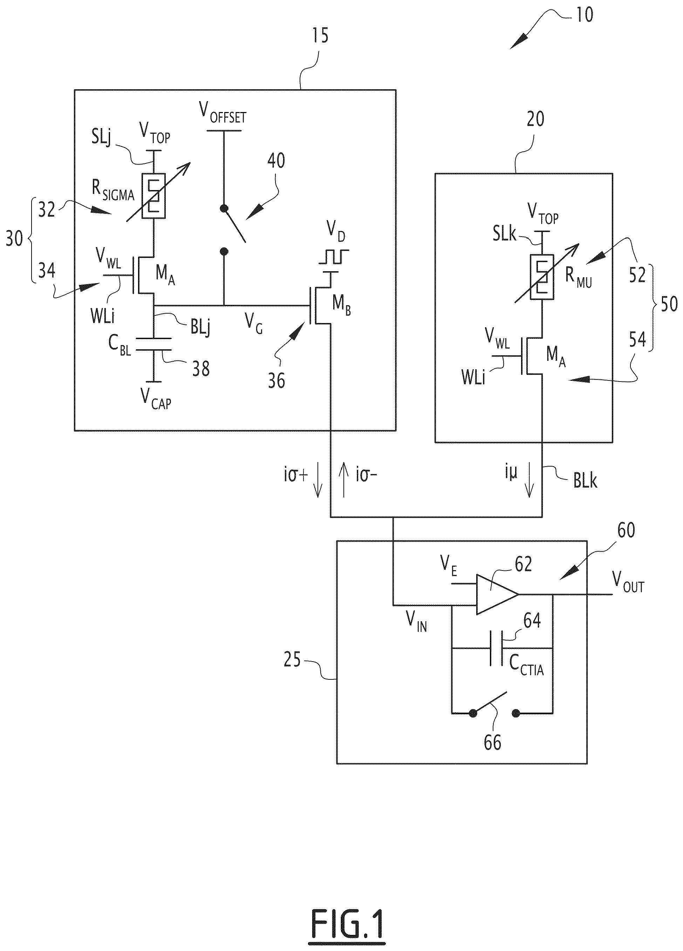

- la figure 1 est une représentation schématique d'un circuit électronique, selon l'invention, comprenant des lignes de bit ; des lignes de source ; au moins une ligne de mot ; au moins une branche primaire, chacune comportant au moins une cellule primaire incluant un composant mémoire primaire et un commutateur primaire ; au moins une branche secondaire, chacune comportant au moins une cellule secondaire incluant un composant mémoire secondaire et un commutateur secondaire ; et un dispositif d'accumulation connecté aux branches primaire(s) et secondaire(s) pour accumuler une quantité totale de charges électriques issues d'une paire respective de cellules ; la figure 1 étant selon un premier mode de réalisation du circuit sans ajout de cascode, selon un premier exemple de réalisation de la branche primaire avec en outre un convertisseur tension-courant de la cellule primaire, selon un premier type - dit capacitif - de cellule primaire, et selon un premier type de cellule secondaire ;

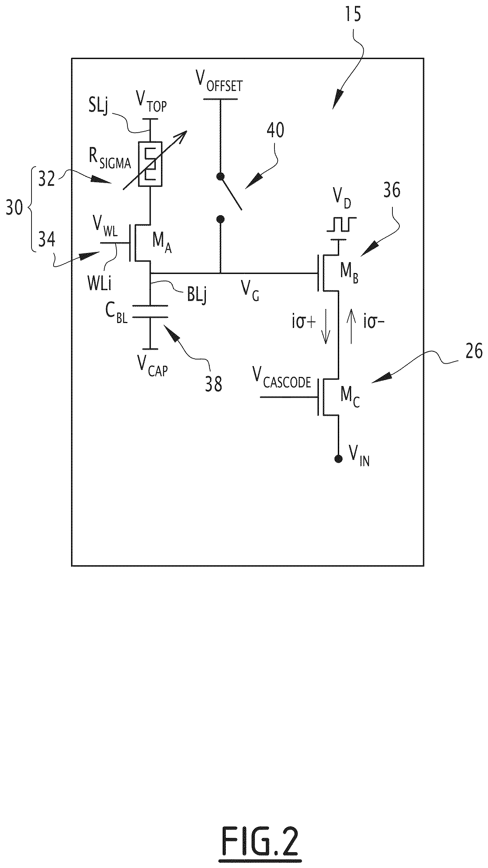

- la figure 2 est une représentation schématique partielle du circuit électronique où la branche secondaire et le dispositif d'accumulation ne sont pas représentés, selon un deuxième mode de réalisation du circuit avec en outre un cascode, dit cascode primaire, connecté entre une branche primaire respective et le dispositif d'accumulation ;

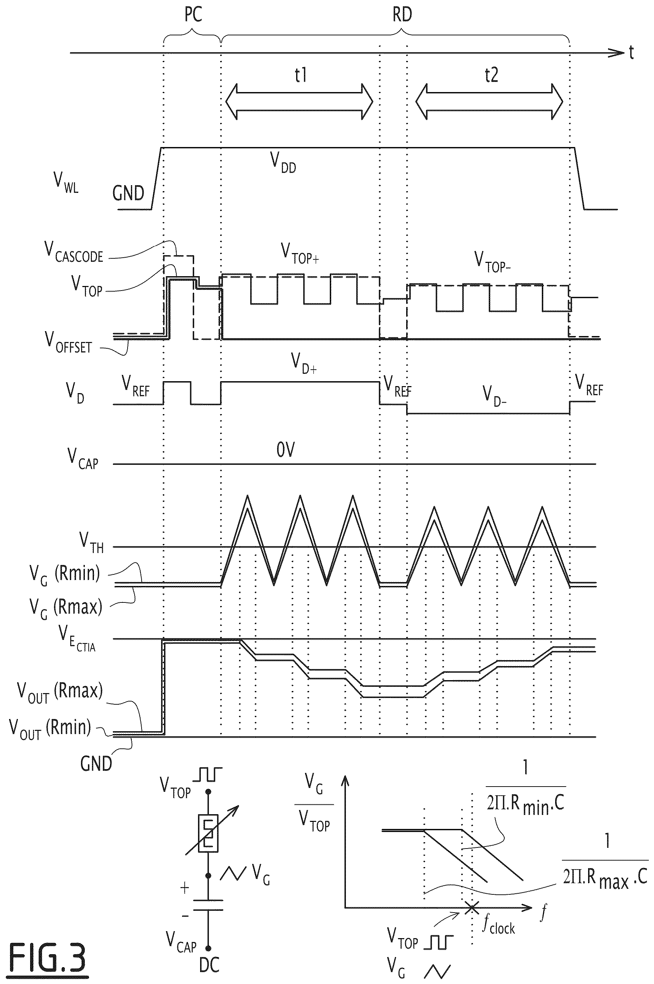

- la figure 3 est un ensemble de courbes schématiques de différentes grandeurs illustrant le fonctionnement du circuit électronique selon le deuxième mode de réalisation et suivant une première mise en œuvre où un signal de forme carrée, i.e. en forme de créneau, est appliqué au composant mémoire primaire afin de polariser la cellule primaire ;

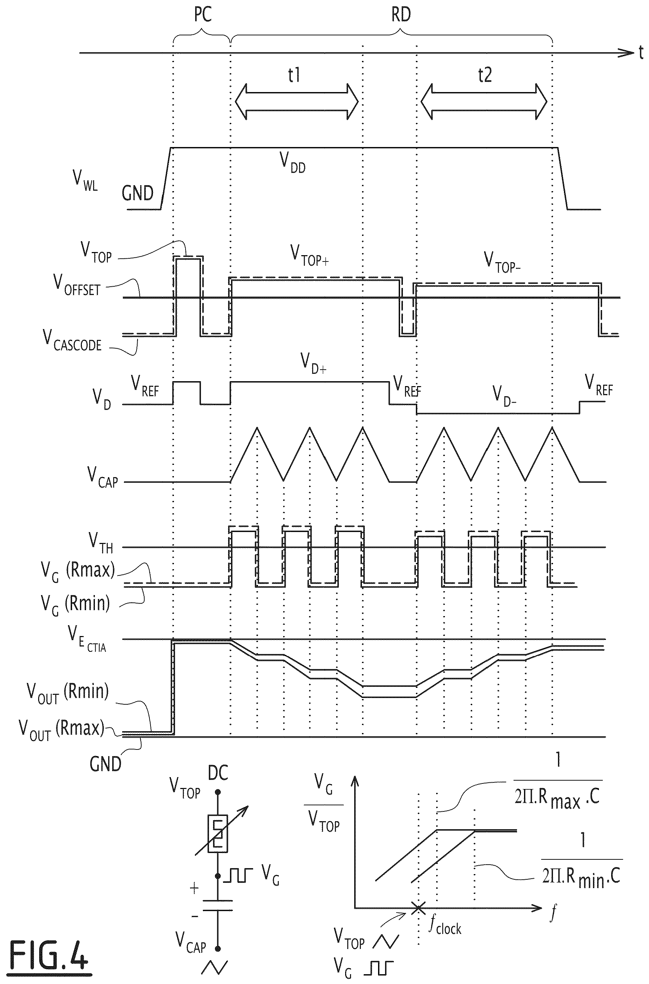

- la figure 4 est une vue analogue à celle de la figure 3, suivant une deuxième mise en œuvre où un signal de forme triangulaire est appliqué à un condensateur de la branche primaire afin de polariser la cellule primaire ;

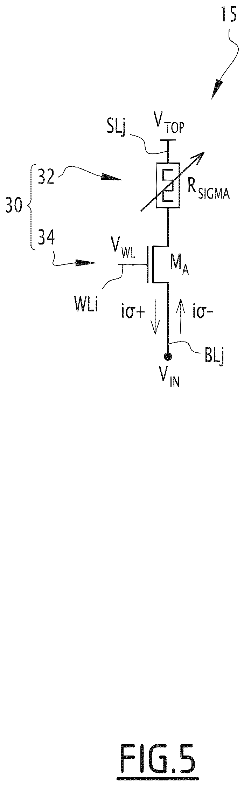

- la figure 5 est une représentation schématique de la branche primaire, selon un deuxième type - dit résistif - de cellule primaire, et selon un premier exemple sans ajout de conductance variable ;

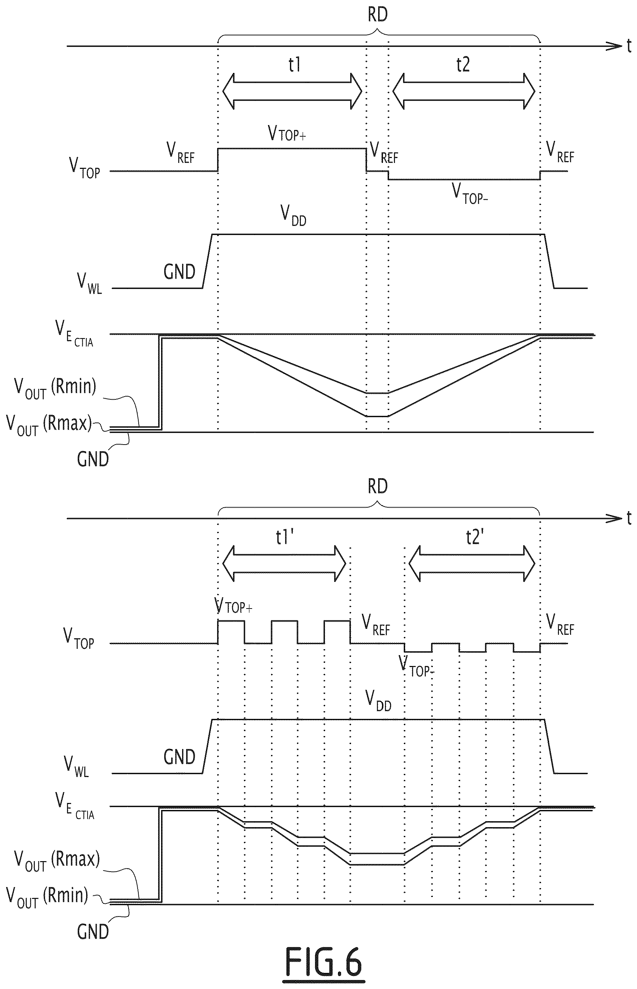

- la figure 6 est un ensemble de courbes schématiques de différentes grandeurs illustrant le fonctionnement de la branche primaire de la figure 5 ;

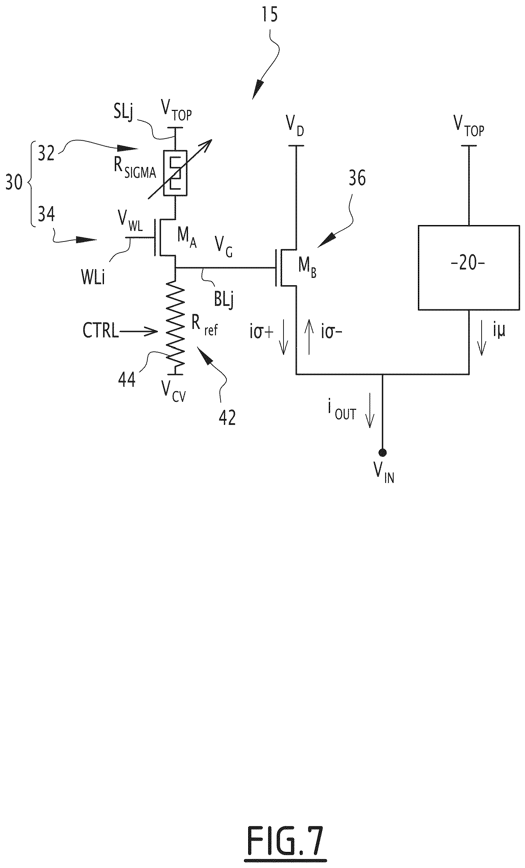

- la figure 7 est une représentation schématique de la branche primaire et de la branche secondaire connectées en parallèle, la branche primaire étant selon le deuxième type - dit résistif - de cellule primaire, et selon un deuxième exemple avec ajout de conductance variable ;

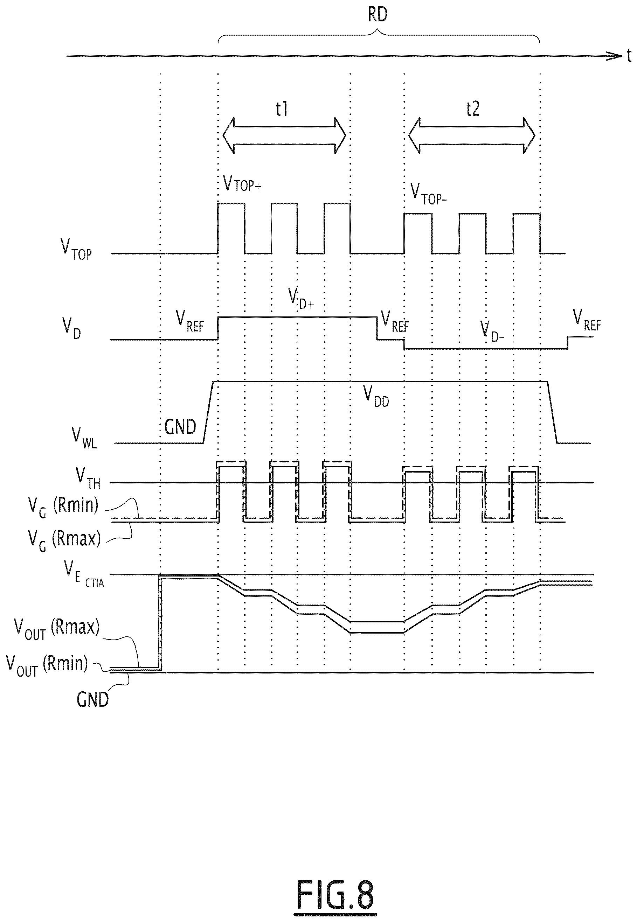

- la figure 8 est une vue analogue à celle de la figure 6, pour la cellule primaire de la figure 7 ;

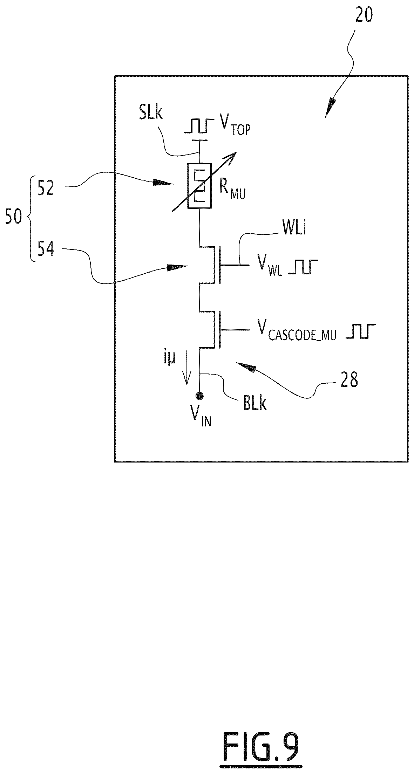

- la figure 9 est une représentation schématique partielle du circuit électronique où la branche primaire et le dispositif d'accumulation ne sont pas représentés, selon un troisième mode de réalisation du circuit avec en outre un cascode, dit cascode secondaire, connecté entre une branche secondaire respective et le dispositif d'accumulation ;

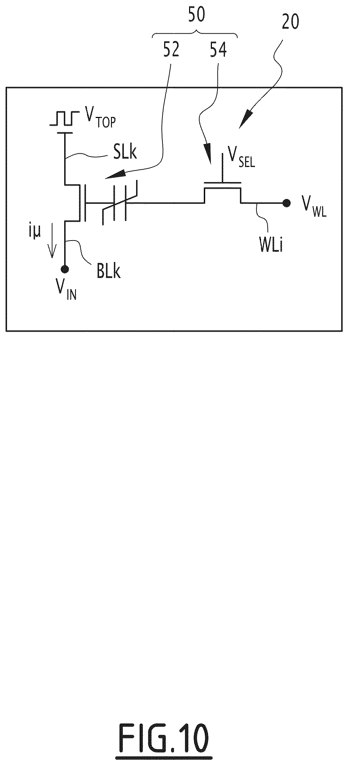

- la figure 10 est une représentation schématique de la branche secondaire, selon un deuxième type de la cellule secondaire où le composant mémoire secondaire est un FeFET ou un FeMFET ;

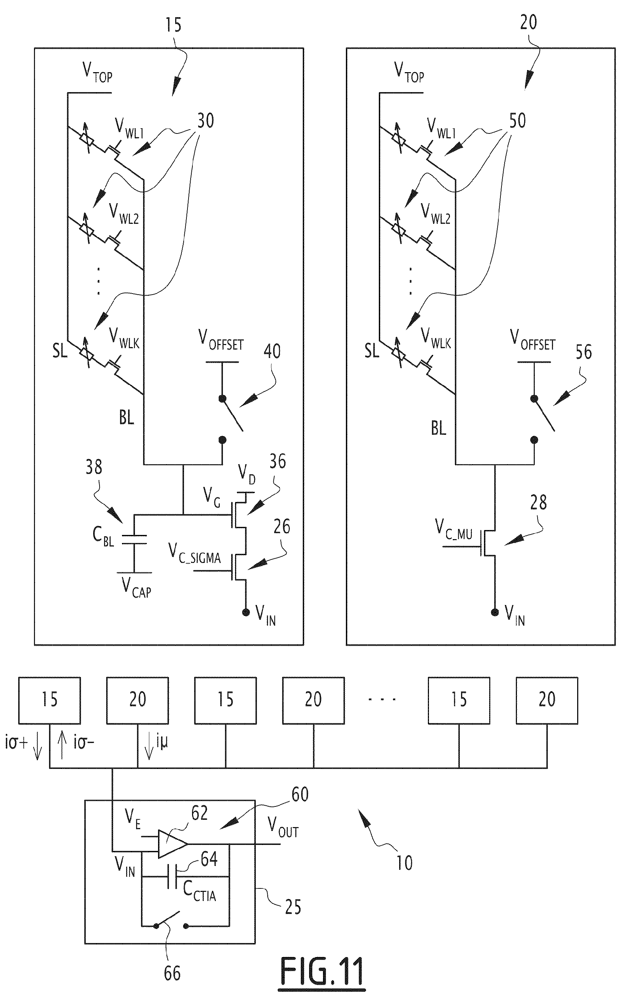

- la figure 11 est une représentation schématique de l'agencement en parallèle de plusieurs branches primaires et secondaires du circuit, chaque branche comportant typiquement plusieurs cellules, selon un premier agencement avec N branches primaires, N branches secondaires, $N \geq 2$, et le dispositif d'accumulation comportant un seul amplificateur à transimpédance connecté auxdites N branches primaires et secondaires ;

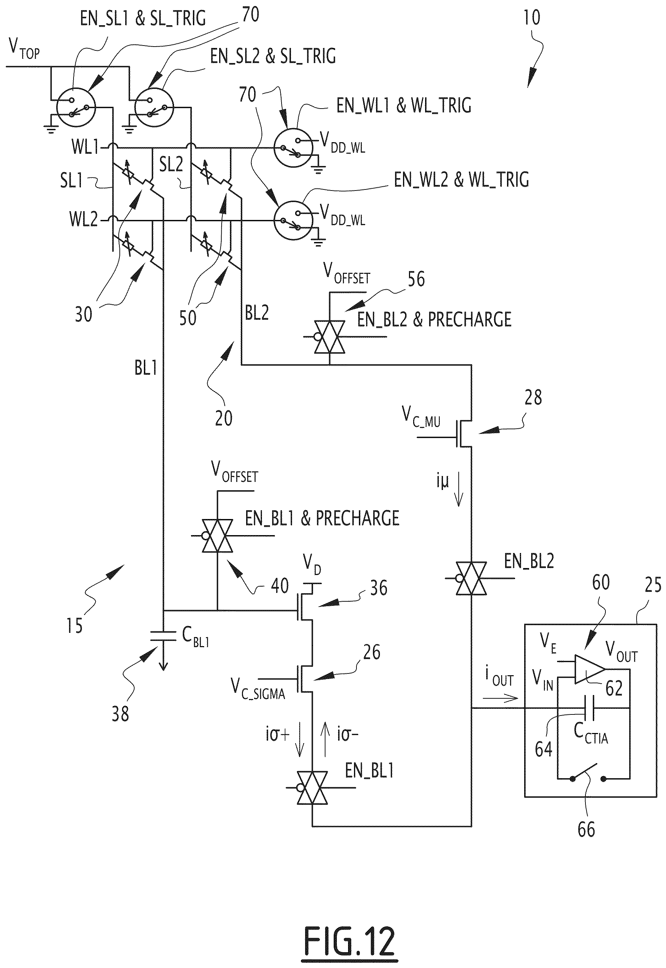

- la figure 12 est une vue schématique d'un exemple d'implémentation avec représentation d'unités logiques de commande de lignes dans le cas d'une branche primaire et d'une branche secondaire connectées en parallèle en entrée d'un amplificateur à transimpédance, selon un quatrième mode de réalisation du circuit avec à la fois le cascode primaire connecté entre la branche primaire et le dispositif d'accumulation et le cascode secondaire connecté entre la branche secondaire et le dispositif d'accumulation ;

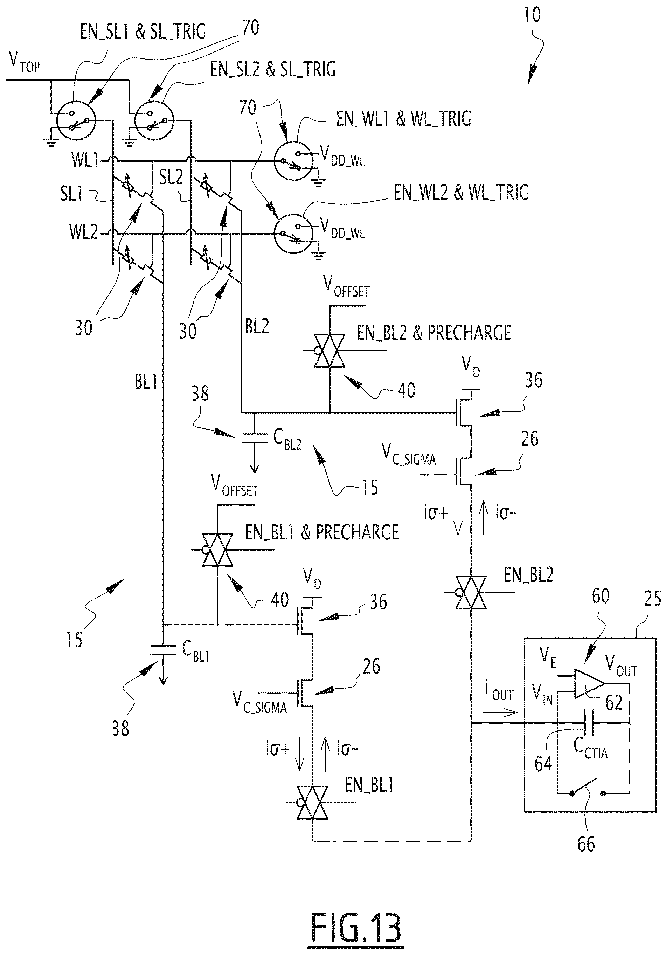

- la figure 13 est une vue analogue à celle de la figure 12, dans le cas de deux branches primaires connectées en parallèle en entrée de l'amplificateur à transimpédance ; et

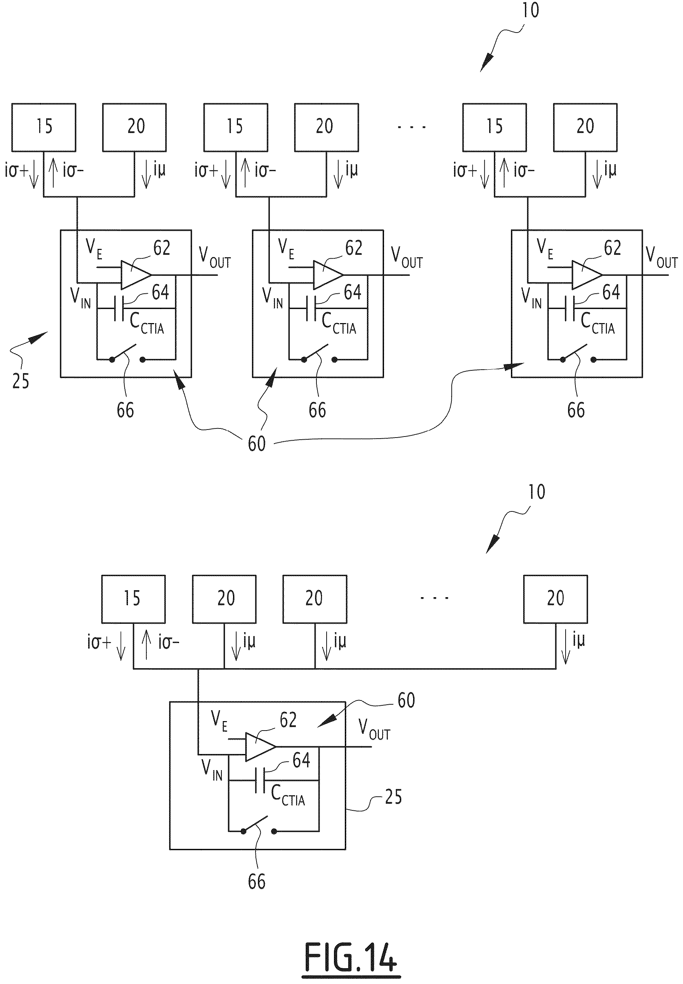

- la figure 14 illustre deux représentations schématiques de l'agencement en parallèle des branches primaire(s) et secondaires du circuit ; l'une étant selon un deuxième agencement avec N paires de branches primaire et secondaire, $N \geq 2$, et le dispositif d'accumulation comportant N amplificateurs à transimpédance, chacun étant connecté à une paire respective de branches primaire et secondaire ; l'autre étant selon un troisième agencement avec une seule branche primaire, N branches secondaires, $N \geq 2$, et le dispositif d'accumulation comportant un seul amplificateur à transimpédance connecté auxdites branches primaire et secondaires.

Un circuit électronique 10 pour la mise en œuvre d'un réseau neuronal bayésien comprend des lignes de bit BLj, avec j indice entier supérieur ou égal à 1, telles que des première BL1 et deuxième BL2 lignes de bit, visible sur les figures 12 et 13 ; des lignes de source SLj, telles que des première SL1 et deuxième SL2 lignes de source, aussi visibles sur les figures 12 et 13 ; et au moins une ligne de mot WLi, avec i indice entier supérieur ou égal à 1, telles que des première WL1 et deuxième WL2 lignes de mot, représentées sur les figures 12 et 13.

Le circuit électronique 10 comprend également au moins une branche primaire 15, au moins une branche secondaire 20, et un dispositif d'accumulation 25 connecté aux branches primaire(s) 15 et secondaire(s) 20.

Dans l'exemple de la figure 1, le circuit électronique 10 représenté comprend une seule branche primaire 15 et une seule branche secondaire 20.

Sur les figures 11 et 14 représentant différents exemples d'agencement en parallèle des branches primaire(s) 15 et secondaires 20, le circuit électronique 10 comprend plusieurs branches secondaires 20 et une ou plusieurs branches primaires 15 selon les exemples.

En complément facultatif, tel que dans les exemples des figures 2 et 11 à 13, le circuit électronique 10 comporte en outre un cascode, dit cascode primaire 26, connecté entre une branche primaire 15 respective et le dispositif d'accumulation 25.

En complément facultatif encore, tel que dans les exemples des figures 9, 11 et 12, le circuit électronique 10 comporte en outre un autre cascode, dit cascode secondaire 28, connecté entre une branche secondaire 20 respective et le dispositif d'accumulation 25.

Chaque branche primaire 15 comporte au moins une cellule primaire 30 connectée entre une ligne de source SLj et une ligne de bit BLj respectives, chaque cellule primaire 30 incluant un composant mémoire primaire 32 et un commutateur primaire 34 connectés en série.

Dans les exemples des figures 11 à 13, chaque branche primaire 15 comporte plusieurs cellules primaires 30 connectées en parallèle les unes des autres entre la ligne de source SLj et la ligne de bit BLj respectives, chaque cellule primaire 30 ayant une extrémité connectée à ladite ligne de source SLj et l'autre extrémité connectée à ladite ligne de bit BLj.

En complément, selon un premier exemple de réalisation de la branche primaire 15, tel que représenté sur les figures 1, 2, 7 et 11 à 13, la branche primaire 15 comporte en outre un convertisseur tension-courant 36 de la cellule mémoire primaire 30, le convertisseur tension-courant 36 étant connecté entre un potentiel additionnel $V_D$ et le dispositif d'accumulation 25.

En variante, selon un deuxième exemple de réalisation de la branche primaire 15, tel que représenté sur la figure 5, la branche primaire 15 ne comporte pas de convertisseur tension-courant.

Selon un premier type - dit capacitif - de la branche primaire 15, tel que représenté sur les figures 1 à 4 et 11 à 13, la branche primaire 15 comporte en outre un condensateur 38 ayant une borne connectée au convertisseur tension-courant 36 et l'autre borne à un potentiel de référence $V_{CAP}$.

Selon ce premier type, la branche primaire 15 comporte avantageusement un premier commutateur auxiliaire 40 connecté entre la borne du condensateur 38 qui est connectée au convertisseur tension-courant 36 et un potentiel $V_{OFFSET}$ de pré-charge du condensateur 38. Le premier commutateur auxiliaire 40 sert alors pour précharger le condensateur 38. Le premier commutateur auxiliaire 40 sert aussi à donner un accès pour programmer la ou les cellules primaires 30 correspondantes.

En variante, la branche primaire 15 est d'un deuxième type, dit résistif, tel que représenté sur les figures 5 et 7.

Dans l'exemple de la figure 5, la branche primaire 15 comporte seulement la cellule primaire 30, c'est-à-dire seulement le composant mémoire primaire 32 et le commutateur primaire 34.

Dans l'exemple de la figure 7, selon un complément facultatif pour le deuxième type - dit résistif - de la branche primaire 15, la branche primaire 15 comporte en outre une conductance variable 42, connectée entre un potentiel de référence $V_{CV}$ et le convertisseur tension-courant 36. La conductance variable 42 est par exemple une résistance variable 44 dont la valeur de résistance Rref est contrôlée par le paramètre CTRL.

Chaque branche primaire 15 est également appelée première branche. En outre, avec le circuit électronique 10 selon l'invention, chaque écart-type de distribution gaussienne est stocké dans une cellule primaire 30 respective. L'écart-type étant généralement représenté par la lettre grecque sigma, chaque branche primaire 15 est également appelée branche sigma.

Chaque branche secondaire 20 comporte au moins une cellule secondaire 50 connectée entre une ligne de source SLk et une ligne de bit BLk respectives, chaque cellule secondaire 50 incluant un composant mémoire secondaire 52 et un commutateur secondaire 54 connectés entre eux. Les lignes de source SLk et de bit BLk associées à chaque branche secondaire 20 sont distinctes des lignes de source SLj et de bit BLj associées à chaque branche primaire 15.

Dans les exemples des figures 11 et 12, chaque branche secondaire 20 comporte plusieurs cellules secondaires 50 connectées en parallèle les unes des autres entre la ligne de source SLj et la ligne de bit BLj respectives, chaque cellule secondaire 50 ayant une extrémité connectée à ladite ligne de source SLj et l'autre extrémité connectée à ladite ligne de bit BLj.

En complément facultatif, la branche secondaire 20 comporte un deuxième commutateur auxiliaire 56 connecté entre le cascode secondaire 28 et le potentiel de pré-charge $V_{OFFSET}$, comme représenté aux figures 11 et 12. Le deuxième commutateur auxiliaire 56 sert à donner un accès pour programmer la ou les cellules secondaires 50 correspondantes.

Chaque branche secondaire 20 est également appelée deuxième branche. En outre, avec le circuit électronique 10 selon l'invention, chaque valeur moyenne de distribution gaussienne est stockée dans une cellule secondaire 50 respective. La valeur moyenne étant généralement représentée par la lettre grecque mu, chaque branche secondaire 20 est également appelée branche mu.

Le dispositif d'accumulation 25 est configuré pour accumuler la quantité totale $Q_{tot}$ de charges électriques issues d'une paire respective de cellules 30, 50, la paire étant formée d'une cellule primaire 30 respective et d'une cellule secondaire 50 respective, la quantité totale $Q_{tot}$ étant la somme d'une quantité primaire $Q_{\sigma}$ de charges issues de ladite cellule primaire 30 et d'une quantité secondaire $Q_{\mu}$ de charges issues de ladite cellule secondaire 50, la quantité primaire $Q_{\sigma}$ et la quantité secondaire $Q_{\mu}$ étant accumulées indépendamment l'une de l'autre.

Avantageusement, le dispositif d'accumulation 25 est configuré pour accumuler la quantité primaire $Q_{\sigma}$ au cours de deux phases successives, à savoir une phase de charge avec une première valeur de tension $V_{TOP+}$ appliquée à la ligne de source SLj correspondante, et une phase de décharge avec une deuxième valeur de tension $V_{TOP-}$ appliquée à ladite ligne de source SLj, la deuxième valeur $V_{TOP-}$ étant distincte de la première valeur $V_{TOP+}$.

Lorsqu'en complément la branche primaire 15 comporte en outre le convertisseur tension-courant 36 connecté entre le potentiel additionnel $V_D$ et le dispositif d'accumulation 25, le potentiel additionnel $V_D$ présente préférentiellement une valeur $V_{D+}$ supérieure à un potentiel de référence $V_E$ en entrée du dispositif d'accumulation 25 lors de la phase de charge, et une valeur $V_{D-}$ inférieure au potentiel de référence $V_E$ en entrée du dispositif d'accumulation 25 lors de la phase de décharge.

Dans les exemples des figures 1 et 11 à 14, le dispositif d'accumulation 25 comporte au moins un amplificateur à transimpédance 60. L'amplificateur à transimpédance 60 est connu en soi, et est également noté TIA (de l'anglais *Transimpedance Amplifier*). L'amplificateur à transimpédance 60 est configuré pour convertir un courant d'entrée en une tension de sortie $V_{OUT}$ proportionnelle. Avantageusement, l'amplificateur à transimpédance 60 est un amplificateur à transimpédance capacitive, également noté CTIA (de l'anglais *Capacitive Transimpedance Amplifier*), en incluant un ou plusieurs éléments capacitifs pour améliorer certaines caractéristiques de performance, telles que la réponse en fréquence et la réduction du bruit.

Dans les exemples des figures 1 et 11 à 14, l'amplificateur à transimpédance 60 est un CTIA, et comporte un amplificateur opérationnel 62 recevant en ses bornes d'entrée, d'une part, le potentiel de référence $V_E$, décrit précédemment, et d'autre part, une tension d'entrée $V_{IN}$ en le point de connexion de la paire respective de cellules primaire 30 et secondaire 50, et délivrant en sa borne de sortie la tension de sortie $V_{OUT}$. L'amplificateur à transimpédance 60 comporte en outre un condensateur de rétroaction 64 de capacité $C_{CTIA}$ et un commutateur de pilotage 66, le condensateur de rétroaction 64 et le commutateur de pilotage 66 étant connectés en parallèle l'un de l'autre entre la borne de sortie de l'amplificateur opérationnel 62 et la borne d'entrée recevant la tension d'entrée V$_{IN}$.

Dans les exemples des figures 1 et 11 à 13, ainsi que dans celui en partie inférieure de la figure 14, le dispositif d'accumulation 25 comporte un seul amplificateur à transimpédance 60. En variante, tel que dans l'exemple en partie supérieure de la figure 14, le dispositif d'accumulation 25 comporte plusieurs amplificateurs à transimpédance 60, avec typiquement alors un amplificateur à transimpédance 60 pour chaque paire de branches primaire 15 et secondaire 20.

Chaque composant mémoire primaire 32 est avantageusement une mémoire sensible au bruit télégraphique aléatoire, également appelé RTN (de l'anglais *Random Telegraphic Noise*).

Chaque composant mémoire primaire 32 est avantageusement une mémoire vive non-volatile.

Chaque composant mémoire primaire 32 est par exemple une mémoire choisie parmi le groupe consistant en : une mémoire vive résistive à base d'oxyde, aussi appelée OxRAM (de l'anglais *Oxide-based Resistive Random Access Memory*) ; une mémoire vive à pontage conducteur, aussi appelée CBRAM (de l'anglais *Conductive Bridging Random Access Memory*) ; une mémoire vie à changement de phase, aussi appelée PCM (de l'anglais Phase-Change Memory) ; une mémoire vive magnétique, aussi appelée MRAM (de l'anglais *Magnetoresistive Random Access Memory*) ; et une mémoire ferroélectrique à jonctions tunnel, aussi appelée FTJ (de l'anglais *Ferroelectric Tunnel Junction*).

Dans les exemples des figures 1 à 8 et 11 à 13, le composant mémoire primaire 32 est une mémoire vive résistive, de résistance notée R$_{SIGMA}$.

Chacun des commutateurs parmi le commutateur primaire 34, le premier commutateur auxiliaire 40, le commutateur secondaire 54 et le deuxième commutateur auxiliaire 56 et le commutateur de pilotage 66 comporte deux électrodes de conduction et une électrode de commande pour commander la commutation du commutateur correspondant entre un état passant dans lequel un courant circule entre les électrodes de conduction et un état bloqué dans lequel le courant ne circule pas entre les électrodes de conduction. L'homme du métier observera que lorsque le commutateur considéré est un transistor, tel qu'un transistor à effet de champ à métal-oxyde-semiconducteur, ou MOSFET (de l'anglais *Metal-Oxide-Semiconductor Field-Effect Transistor*), alors les électrodes de conduction sont les électrodes de drain et de source, et l'électrode de commande est l'électrode de grille.

Le commutateur primaire 34 a son électrode de commande connectée à une ligne de mot WLi respective. Le commutateur primaire 34 est utilisé pour la programmation du composant mémoire primaire 32 auquel il est connecté. Autrement dit, le commutateur primaire 34 est utilisé pour le stockage de la valeur souhaitée dans le composant mémoire primaire 32.

Dans les exemples des figures 1 à 8 et 11 à 13, le commutateur primaire 34 est un transistor MOSFET, noté M$_A$, dont l'électrode de grille est pilotée par une tension V$_{WL}$ associée à la ligne de mot WLi respective.

Le convertisseur tension-courant 36 a son électrode de commande reliée à la cellule mémoire primaire via la ligne de bit BLj correspondante. Le convertisseur tension-courant 36 est utilisé pour amplifier des variations d'une tension V$_G$ issue du composant mémoire primaire 32 via la ligne de bit BLj correspondante.

Dans les exemples des figures 1 à 4, 7, 8 et 11 à 13, le convertisseur tension-courant 36 est un transistor MOSFET, noté M$_B$, dont l'électrode de grille est pilotée par la tension V$_G$.

Le condensateur 38 a une borne connectée à l'électrode de commande du convertisseur tension-courant 36 et l'autre borne à un potentiel de référence V$_{CAP}$, et présente une capacité C$_{BL}$.

Le premier commutateur auxiliaire 40 est connecté entre le potentiel V$_{OFFSET}$ de pré-charge du condensateur 38 et la borne du condensateur 38 qui est connectée à l'électrode de commande du convertisseur tension-courant 36.

La conductance variable 42 est connectée entre le potentiel de référence V$_{CV}$ et l'électrode de commande du convertisseur tension-courant 36. Dans l'exemple de la figure 7, la conductance variable 42 est réalisée via la résistance variable 44 contrôlée par le paramètre CTRL.

Chaque composant mémoire secondaire 52 est avantageusement une mémoire vive non-volatile.

Dans les exemples des figures 1, 9, 11 et 12, selon un premier type de la cellule secondaire 50, chaque composant mémoire secondaire 52 est une mémoire choisie parmi le groupe consistant en : une mémoire vive résistive à base d'oxyde, aussi appelée OxRAM ; une mémoire vive à pontage conducteur, aussi appelée CBRAM ; une mémoire vie à changement de phase, aussi appelée PCM ; une mémoire vive magnétique, aussi appelée MRAM ; et une mémoire ferroélectrique à jonctions tunnel, aussi appelée FTJ ; et une mémoire ferroélectrique aussi appelée FeRAM.

Dans ces exemples des figures 1, 9, 11 et 12, le composant mémoire secondaire 52 et le commutateur secondaire 54 sont connectés en série entre la ligne de source SLk et la ligne de bit BLk respectives, le commutateur secondaire 54 ayant une électrode de commande connectée à une ligne de mot WLj respective.

Dans ces exemples des figures 1, 9, 11 et 12, le composant mémoire secondaire 52 est une mémoire vive résistive, de résistance notée R$_{MU}$.

En variante, selon un deuxième type de la cellule secondaire 50, chaque composant mémoire secondaire 52 comporte un transistor à effet de champ utilisant un matériau ferroélectrique.

Selon cette variante, chaque composant mémoire secondaire 52 est par exemple un transistor à effet de champ à mémoire ferroélectrique, aussi appelée FeMFET (de l'anglais *Ferroelectric-Metal Field-Effect Transistor*), comme représenté sur la figure 10; ou encore un transistor à effet de champ ferroélectrique, aussi appelée FeFET (de l'anglais *Ferroelectric Field-Effect Transistor*). Le FeMFET est un type de transistor à effet de champ dont la grille est connectée à une capacité ferroélectrique réalisée par une jonction métal - diélectrique ferroélectrique - métal. La polarisation de la couche ferroélectrique modifie les propriétés électriques du FeMFET, permettant son utilisation en mémoire non-volatile. Le FeFET est un transistor à effet de champ utilisant un matériau ferroélectrique comme diélectrique de grille, et la polarisation du diélectrique ferroélectrique permet de contrôler le canal de conduction, offrant ainsi une mémoire non-volatile avec des caractéristiques similaires à celles des transistors MOSFET. Dans les 2 cas, le FeMFET et le FeFET sont sujets à un décalage de leurs tensions de seuil lorsque la polarisation ferroélectrique change.

Selon cette variante, le composant mémoire secondaire 52 est connecté entre la ligne de source SLk et la ligne de bit BLk respectives et le commutateur secondaire 54 est connecté entre une ligne de mot WLj et une électrode de commande du composant mémoire secondaire 52. Selon cette variante, le commutateur secondaire 54 est alors configuré pour sélectionner le composant mémoire secondaire 52 auquel il est associé, cette sélection étant effectuée en appliquant la tension $V_{SEL}$ sur l'électrode de commande du commutateur secondaire 54, et lorsque le commutateur secondaire 54 est dans son état passant, il autorise alors l'application de la tension $V_{WL}$ à l'électrode de commande du composant mémoire secondaire 52, cette tension $V_{WL}$ étant reçue via la ligne de mot WLi connectée au commutateur secondaire 54.

Le fonctionnement du circuit électrique 10 selon l'invention va être à présent expliqué, notamment en regard des figures 3, 4, 6 et 8, ces figures représentant des ensembles de courbes schématiques de différentes grandeurs impliquées dans le fonctionnement du circuit électrique 10 selon l'invention, notamment de différentes tensions appliquées à des éléments du circuit électrique 10.

L'homme du métier observera en particulier que les tensions représentées sur chacune de ces figures 3, 4, 6 et 8 correspondent à celles indiquées sur le circuit électrique 10 de chacune des figures les précédant, les tensions représentées aux figures 3 et 4 étant alors visibles sur la figure 2, et partiellement sur la figure 1, de même les tensions représentées à la figure 6 étant visibles à la figure 5, et celles représentées à la figure 8 étant visibles à la figure 7.

Ainsi, sur les figures 3 et 4, les tensions sont respectivement les suivantes, en partant du haut vers le bas :

- la tension $V_{WL}$ appliquée à l'électrode de commande du commutateur primaire 34 via la ligne de mot WLi, cette tension $V_{WL}$ variant entre un potentiel bas formé par le potentiel GND d'une masse électrique et un potentiel haut noté $V_{DD}$ ;
- une tension $V_{CASCODE}$ appliquée à l'électrode de commande du cascode primaire 26, représentée en trait pointillé ;
- la tension $V_{TOP}$ appliquée au composant mémoire primaire 32 via la ligne de source SLj, prenant notamment la première valeur de tension $V_{TOP_+}$ en phase de charge et la deuxième valeur de tension $V_{TOP_-}$ en phase de décharge ;
- une tension $V_{OFFSET}$ appliquée en une extrémité du premier commutateur auxiliaire 40 et servant à pré-charger le condensateur 38 ;
- une tension $V_D$ appliquée en une extrémité du convertisseur tension-courant 36, prenant une valeur $V_{D+}$ en phase de charge, une valeur $V_{D-}$ en phase de décharge et une valeur $V_{REF}$ sinon, la valeur $V_{REF}$ étant une valeur de référence de la tension d'entrée $V_{IN}$ correspondant à un équilibre de charges, i.e. à une absence d'accumulation de charges par le dispositif d'accumulation 25, la valeur $V_{REF}$ étant également appelée tension de pré-charge du dispositif d'accumulation 25 ;
- une tension $V_{CAP}$ appliquée en la borne inférieure du condensateur 38 ; une source de tension constante (reliée à la masse dans l'exemple de la figure 3) ou dynamique (figure 4)
- une tension de seuil $V_{TH}$ du convertisseur tension-courant 36 ;
- la tension $V_G$, également appelée tension de grille $V_G$, appliquée à l'électrode de commande du convertisseur tension-courant 36 ; et l'homme du métier observera que la valeur de cette tension $V_G$ dépend de la valeur du composant mémoire primaire 32, telle que la valeur de la résistance $R_{SIGMA}$, la tension $V_G$ étant alors variable en fonction de la valeur de de la résistance $R_{SIGMA}$, avec représentation aux figures 3 et 4 à la fois d'une courbe notée $V_G$(Rmin) pour une valeur minimale Rmin de cette résistance $R_{SIGMA}$, et d'une courbe notée $V_G$(Rmax) pour une valeur maximale Rmax de cette résistance $R_{SIGMA}$ ;
- le potentiel de référence $V_E$ reçu en entrée de l'amplificateur à transimpédance 60, aussi noté $V_{E\_CTIA}$ ;
- la tension de sortie $V_{OUT}$ en sortie du dispositif d'accumulation 25 ; et l'homme du métier notera que la valeur de cette tension de sortie $V_{OUT}$ dépend également de la valeur du composant mémoire primaire 32, telle que la valeur de la résistance $R_{SIGMA}$, la tension de sortie $V_{OUT}$ étant alors variable en fonction de la valeur de de la résistance $R_{SIGMA}$, avec représentation aux figures 3 et 4 à la fois d'une courbe notée $V_{OUT}$(Rmin) pour la valeur minimale Rmin de cette résistance $R_{SIGMA}$, et d'une courbe notée $V_{OUT}$(Rmax) pour la valeur maximale Rmax de cette résistance $R_{SIGMA}$ ; et
- le potentiel GND de la masse électrique.

Les tensions représentées aux figures 6 et 8 sont chacune parmi celles définies ci-dessus.

Le circuit électrique 10 selon l'invention forme un générateur gaussien transitoire avec bruit RTN et utilise la variabilité en lecture des composants mémoire primaire 32 et secondaire 52 pour construire un générateur de gaussiennes transitoires, un tel générateur étant particulièrement utile pour l'implémentation matérielle de réseaux neuronaux bayésiens. Les propriétés de chaque distribution gaussienne sont alors contrôlées par un couple de valeurs moyenne et d'écart-type, chacune étant stockée dans un composant mémoire 32, 52 respectif, chaque valeur d'écart-type étant stockée dans un composant mémoire primaire 32 respectif et chaque valeur moyenne dans un composant mémoire secondaire 52 respectif.

Pour la lecture de ces valeurs, le principe est d'effectuer une accumulation de charges via le dispositif d'accumulation 25, la quantité totale $Q_{tot}$ étant alors la somme de la quantité primaire $Q_\sigma$ de charges issues de ladite cellule primaire 30 et de la quantité secondaire $Q_\mu$ de charges issues de ladite cellule secondaire 50, et cette quantité totale $Q_{tot}$ étant reliée à la tension de sortie $V_{OUT}$ en sortie du dispositif d'accumulation 25 via l'équation suivante :

[1]

$$Q_{tot} = Q_\sigma + Q_\mu = C_{CTIA}.(V_E - V_{OUT})$$

où $Q_{tot}$ représente la quantité totale,
$Q_\sigma$ représente la quantité primaire,
$Q_\mu$ représente la quantité secondaire,
$C_{CTIA}$ représente la capacité du condensateur de rétroaction 64 d'un amplificateur à transimpédance capacitive respectif du dispositif d'accumulation 25,
$V_E$ représente le potentiel de référence reçu en entrée de l'amplificateur à transimpédance, ce potentiel de référence $V_E$ étant par exemple égal à la valeur $V_{REF}$, i.e. à la tension de pré-charge du dispositif d'accumulation 25 et
$V_{OUT}$ représente la tension de sortie dudit amplificateur à transimpédance capacitive respectif.

Comme représenté notamment à la figure 1, la quantité primaire $Q_\sigma$ de charges issues de ladite cellule primaire 30 correspond à la variation de charges résultant d'une part d'un courant iσ+ circulant depuis la cellule primaire 30 respective vers le dispositif d'accumulation 25 et d'autre part d'un courant iσ- circulant en sens inverse depuis le dispositif d'accumulation 25 vers la cellule primaire 30 respective.

Plus précisément, la quantité primaire $Q_\sigma$ vérifie l'équation suivante :

[2]

$$Q_\sigma = i_{\sigma+}.t_1 - i_{\sigma-}.t_2$$

où $Q_\sigma$ représente la quantité primaire,
iσ+ représente le courant circulant depuis la cellule primaire 30 respective vers le dispositif d'accumulation 25 lors de la phase de charge avec la première valeur de tension $V_{TOP+}$ appliquée à la ligne de source SLj correspondante, pendant une première durée $t_1$ ; et avantageusement en présence du convertisseur tension-courant 36 amplifiant les variations de tension, avec la valeur supérieure $V_{D+}$ du potentiel additionnel $V_D$ ;
iσ- représente le courant circulant en sens inverse depuis le dispositif d'accumulation 25 vers la cellule primaire 30 respective lors de la phase de décharge avec la deuxième valeur de tension $V_{TOP-}$ appliquée à ladite ligne de source SLj, pendant une deuxième durée $t_2$; et avantageusement en présence du convertisseur tension-courant 36 amplifiant les variations de tension, avec la valeur inférieure $V_{D-}$ du potentiel additionnel $V_D$.
La quantité secondaire $Q_\mu$ de charges issues de ladite cellule secondaire 50 respective résulte d'un courant $i_\mu$ circulant depuis la cellule secondaire 50 respective vers le dispositif d'accumulation 25.

Plus précisément, la quantité secondaire $Q_\mu$ vérifie l'équation suivante :

[3]

$$Q_\mu = i_\mu.t_3$$

où $Q_\mu$ représente la quantité secondaire,
$i_\mu$ représente le courant circulant depuis la cellule secondaire 50 respective vers le dispositif d'accumulation 25 lors de la phase de charge, pendant une troisième durée $t_3$, distincte et indépendante des première et deuxième durées $t_1$, $t_2$.

Pour éviter une corrélation entre les valeurs moyenne et d'écart-type, chaque courant iσ d'une part et $i_\mu$ d'autre part est échantillonné indépendamment, mais pas forcément séquentiellement par le dispositif d'accumulation 25.

Pour la cellule primaire 30 respective, du fait des courants iσ+, iσ- circulant en sens inverse successivement lors des phases de charge et de décharge, la quantité primaire $Q_\sigma$ présente une distribution dont la valeur moyenne est indépendante de la valeur du composant mémoire primaire 32, telle que la valeur de la résistance $R_{SIGMA}$, et dont la variance résulte du bruit RTN du composant mémoire primaire 32. La quantité primaire $Q_\sigma$ vérifie alors les équations suivantes :

[4]

$$E(Q_\sigma) = constante \sim 0$$

[5]

$$V(Q_\sigma) = F(R_{SIGMA})$$

où $Q_\sigma$ représente la quantité primaire,
E représente l'espérance
V représente la variance,
F représente une première fonction mathématique, et
$R_{SIGMA}$ représente la résistance du composant mémoire primaire 32.

Pour la cellule secondaire 50 respective, le composant mémoire secondaire 52 est en forme de n'importe quelle mémoire non-volatile tant que le rapport entre la variance et la moyenne reste acceptable. Une plage de valeurs acceptables pour ce rapport entre la variance et la moyenne est typiquement prédéfinie, par exemple en fonction de l'application concernée, et/ou suite à des mesures et/ou simulations effectuées. Par exemple, la plage de valeurs acceptables pour ce rapport entre la variance et la moyenne est [0 ; 0,1], c'est-à-dire une variance au plus égale à 10% de la moyenne.

La quantité secondaire $Q_\mu$ vérifie alors les équations suivantes :

[6]

$$E(Q_\mu) = G(R_{MU})$$

[7]

$$V(Q_\mu) = constante \sim 0$$

où $Q_\mu$ représente la quantité secondaire,
E représente l'espérance
V représente la variance,
G représente une deuxième fonction mathématique, et
$R_{MU}$ représente la résistance du composant mémoire secondaire 52.

En complément, en présence du convertisseur tension-courant 36, celui-ci permet d'amplifier les variations de la tension de grille $V_G$ entre son électrode de grille et le composant mémoire primaire 32. Avantageusement, une forte dépendance entre la valeur, telle que la résistance $R_{SIGMA}$, du composant mémoire primaire 32 et la tension de grille $V_G$ permet de mieux mesurer ces fluctuations. Deux leviers sont alors possibles, un premier levier est un paramètre de processus en faisant en sorte que le niveau de bruit, tel que le bruit RTN, soit maximal à l'état hautement résistif, aussi appelé HRS (de l'anglais *High Resistive State*), du composant mémoire primaire 32 et diminue avec la conductance à l'état faiblement résistif, aussi appelé LRS (de l'anglais *Low Resistive State*), dudit composant mémoire primaire 32. Un deuxième levier est un paramètre de conception en positionnant une fréquence de coupure $f_c$ du filtre RC, formé par le composant mémoire primaire 32 et le condensateur 38, en accord avec une fréquence d'horloge $f_{clock}$ du circuit électronique 10, comme cela sera expliqué plus en détail par la suite en regard des exemples des figures 3 et 4.

Selon ce complément, le convertisseur tension-courant 36 lorsqu'il s'agit d'un MOSFET fonctionne avantageusement en mode inversion, c'est-à-dire avec sa tension $V_{GS}$ supérieure à la tension de seuil $V_{TH}$, pour éviter une distribution lognormale. En effet, lorsque $V_{GS}$ inférieur à $V_{TH}$, le MOSFET fonctionne sous le seuil et le courant est une fonction exponentielle de la tension de grille-source $V_{GS}$. Si la tension $V_{GS}$ suivait une loi normale en fonction du temps, le courant mesuré suivrait une loi lognormale par définition.

Le bruit RTN change la valeur, telle que la résistance $R_{SIGMA}$, du composant mémoire primaire 32 autour de ses valeurs nominales. Dans le cas idéal, illustré en partie supérieure de la figure 6, les valeurs de tension $V_{TOP+}$, $V_{TOP-}$ sont choisies de manière à ce qu'en l'absence de variation de résistance $R_{SIGMA}$, la valeur initiale de la tension de sortie $V_{OUT}$ soit la même que la valeur finale de la tension de sortie $V_{OUT}$: la partie continue, ou DC, est alors supprimée.

Néanmoins, pendant les phases de charge ou de décharge, certains événements RTN peuvent se produire, la résistance $R_{SIGMA}$ étant également sujette au bruit thermique.

La charge accumulée $Q_{tot}$ étant limitée par la capacité $C_{CTIA}$ du condensateur de rétroaction 64 selon la relation $Q_{tot} = C_{CTIA} \cdot (V_E - V_{OUT})$ issue de l'équation [1] précédente, le deuxième type - dit résistif - de la cellule primaire 30, selon le premier exemple sans ajout de conductance variable et sans le convertisseur tension-courant 36, est intéressant si l'on peut contrôler avec précision une courte impulsion de la tension $V_{TOP}$ appliquée au composant mémoire primaire 32 via la ligne de source SLj correspondante. Dans le cas contraire, la capacité $C_{CTIA}$ sera saturée.

Pour éviter la saturation et permettre aux événements RTN de se produire quand même, la valeur de la résistance est échantillonnée en utilisant de courtes impulsions de ladite tension $V_{TOP}$ appliquée au composant mémoire primaire 32, ces impulsions étant répétées et espacées d'un temps d'espacement arbitraire, comme représenté en partie inférieure de la figure 6. Idéalement, l'espacement devrait être plus élevé que les temps d'émission et de capture afin d'accumuler différentes valeurs dans les phases de charge/décharge.

Pour accumuler plus de données utiles sans saturer la capacité $C_{CTIA}$ du condensateur de rétroaction 64, une solution consiste à utiliser une autre architecture, tel que par exemple le deuxième type - dit résistif - de la cellule primaire 30, selon le deuxième exemple avec ajout de la conductance variable 42 et avec le convertisseur tension-courant 36, visible à la figure 7. Lorsque le convertisseur tension-courant 36 est passant, la cellule primaire 30 se simplifie en un diviseur résistif entre les résistances $R_{SIGMA}$ du composant mémoire primaire 32 et Rref de la conductance variable 42. Pour une valeur fixe de la tension $V_{TOP}$ appliquée au composant mémoire primaire 32, toute variation de la résistance $R_{SIGMA}$ du composant mémoire primaire 32 se verra alors sur la tension de grille $V_G$ selon l'équation suivante d'une fonction de transfert H :

[8]

$$H = \frac{V_G - V_{CV}}{V_{TOP} - V_{CV}} = \frac{Rref}{Rref + R_{SIGMA}}$$

où $V_G$ est la tension de grille appliquée à l'électrode de commande du convertisseur tension-courant 36,

$V_{TOP}$ est la tension appliquée au composant mémoire primaire 32 via la ligne de source SLj correspondante,

$V_{CV}$ est la tension appliquée à la deuxième borne de la résistance variable 44,

Rref est la valeur de la résistance variable 44, et

$R_{SIGMA}$ est la résistance du composant mémoire primaire 32.

Comme pour l'exemple précédent des figures 5 et 6, une stratégie d'impulsions est possible pour améliorer la consommation d'énergie de la cellule primaire 30, tel que représenté à la figure 8. La tension aux bornes du convertisseur tension-courant 36, c'est-à-dire la différence de potentiel $V_D - V_{IN}$, peut être choisie aussi petite que possible pour fonctionner dans le régime linéaire du transistor MOSFET $M_B$.

Pour le premier type - dit capacitif - de la cellule primaire 30, correspondant aux exemples des figures 1 à 4, la mise en œuvre du circuit électronique 10 selon l'invention comprend une phase initiale PC de pré-charge à la tension $V_{OFFSET}$ du condensateur 38 et du nœud de connexion du commutateur primaire 34 au condensateur 38, dit nœud flottant, cette phase initiale PC précédant une lecture RD avec phase de charge de durée t1 et phase de décharge de durée t2 aux figures 3 et 4.

Pour la lecture RD avec phases de charge et de décharge, le signal transitoire pour la tension $V_{TOP}$ ou pour la tension $V_{CAP}$ est par exemple de forme carrée ou triangulaire, et la tension $V_G$ dépend de la valeur du composant mémoire primaire 32, telle que la valeur de la résistance $R_{SIGMA}$. L'accumulation du courant circulant à travers le convertisseur tension-courant 36 se traduit alors par un accroissement de charges, c'est-à-dire une phase de charge, lorsque la différence de potentiel $V_D - V_{IN}$ est positive, i.e. lorsque la différence de potentiel $V_D - V_{REF}$ est positive ; et respectivement une diminution de charges, c'est-à-dire une phase de décharge, lorsque la différence de potentiel $V_D - V_{IN}$ est négative, i.e. lorsque la différence de potentiel $V_D - V_{REF}$ est négative. Ces phases de charge, et respectivement de décharge, sont typiquement itérées plusieurs fois au cours de plusieurs cycles successifs.

L'homme du métier observera par ailleurs que lorsque le composant mémoire primaire 32 est une mémoire vive résistive à base d'oxyde, ou OxRAM, la différence de potentiel $V_{TOP} - V_G$ doit être inférieure à la tension de seuil de l'OxRAM pour éviter un effacement de l'OxRAM.

Dans l'exemple de la figure 3, le signal transitoire pour la tension $V_{TOP}$ est de forme carrée et le signal de la tension $V_{CAP}$ est continu, ou DC, la tension $V_G$ étant alors de forme triangulaire. Dans cet exemple de la figure 3, l'ensemble du composant mémoire primaire 32 et du condensateur 38 forme alors un filtre passe-bas jouant un rôle d'intégrateur, et la fonction de transfert H vérifie alors l'équation suivante :

[9]

$$H = \frac{V_G - V_{CAP}}{V_{TOP} - V_{CAP}} = \frac{1}{1 + x}$$

où $V_G$ est la tension appliquée à l'électrode de commande du convertisseur tension-courant 36,
$V_{TOP}$ est la tension appliquée au composant mémoire primaire 32,
avec x vérifiant l'équation :

[10]

$$x = \frac{f}{fc}$$

où f est une fréquence du circuit,
fc est la fréquence de coupure du filtre, et vérifiant l'équation suivante :

[11]

$$f_c = \frac{1}{2.\pi.R_{SIGMA}.C_{BL}}$$

avec $R_{SIGMA}$ la résistance du composant mémoire primaire 32, et
$C_{BL}$ la capacité du condensateur 38, également noté C aux figures 3 et 4.

Sur la figure 3, la fonction de transfert H est représentée schématiquement pour les valeurs minimale Rmin et maximale Rmax de la résistance $R_{SIGMA}$ du composant mémoire primaire 32, avec illustration des fréquences de coupure respectives 1/(2πRmin.C) et 1/(2πRmax.C), où C désigne alors la capacité du condensateur 38.
L'homme du métier remarquera alors que dans cet exemple la fréquence d'horloge $f_{clock}$ est avantageusement choisie supérieure ou égale à la fréquence de coupure $f_c$ du filtre passe-bas pour utiliser la variabilité résultant de la résistance $R_{SIGMA}$ du composant mémoire primaire 32. On notera que si la fréquence d'horloge $f_{clock}$ est égale à 1/(2πRmin.C), la variation de la fonction de transfert H est maximale. Lorsque la fréquence d'horloge $f_{clock}$ est largement supérieure à la fréquence de coupure $f_c$, on est dans la zone d'atténuation du filtre et la relation entre la fonction de transfert H et la résistance $R_{SIGMA}$ n'est plus mesurable.
Dans l'exemple de la figure 4, le signal de la tension $V_{TOP}$ est continu, ou DC, et le signal transitoire pour la tension $V_{CAP}$ est de forme triangulaire, la tension $V_G$ étant alors de forme carrée. Dans cet exemple de la figure 4, l'ensemble du composant mémoire primaire 32 et du condensateur 38 forme alors un filtre passe-haut jouant un rôle de dérivateur, et la fonction de transfert H vérifie alors l'équation suivante :

[12]

$$H = \frac{V_G - V_{CAP}}{V_{TOP} - V_{CAP}} = \frac{x}{1 + x}$$

où $V_G$ est le potentiel appliqué à l'électrode de commande du convertisseur tension-courant 36 également reliée à la première borne du condensateur 38,
$V_{TOP}$ est la tension appliquée au composant mémoire primaire 32,
$V_{CAP}$ est la tension appliquée à la deuxième borne du condensateur 38
avec x vérifiant l'équation [10] précédente.

Sur la figure 4, la fonction de transfert H est également représenté schématiquement pour les valeurs minimale Rmin et maximale Rmax de la résistance $R_{SIGMA}$ du composant mémoire primaire 32, avec illustration des fréquences de coupure respectives 1/(2πRmin.C) et 1/(2πRmax.C), où C désigne alors la capacité du condensateur 38.
L'homme du métier remarquera aussi que dans cet exemple la fréquence d'horloge $f_{clock}$ est avantageusement choisie inférieure ou égale à la fréquence de coupure $f_c$ du filtre passe-haut pour utiliser la variabilité résultant de la résistance $R_{SIGMA}$ du composant mémoire primaire 32. On notera que la fréquence d'horloge $f_{clock}$ est égale à $1/(2\pi Rmax.C)$, la variation de la fonction de transfert H est maximale. Lorsque la fréquence d'horloge $f_{clock}$ est largement inférieure à la fréquence de coupure $f_c$, on est dans la zone d'atténuation du filtre et la relation entre la fonction de transfert H et la résistance $R_{SIGMA}$ n'est plus mesurable.

Dans ces exemples des figures 2 à 4, le cascode primaire 26 permet de limiter, ou encore d'affamer, la décharge de l'amplificateur à transimpédance 60, et également d'amplifier les fluctuations du courant de drain $I_D$ du convertisseur tension-courant 36, lorsqu'il est de type MOSFET, en modulant l'efficacité d'une transconductance $gm/I_D$.

L'homme du métier observera que les courbes des figures 3 et 4 correspondent au circuit électronique de la figure 2, et que celles correspondant au circuit électronique de la figure 1 sont similaires à la différence que la tension $V_{CASCODE}$ est alors supprimée, puisque le circuit électronique de la figure 1 ne comprend pas le cascode primaire 26.

Pour la lecture associée à une cellule secondaire 50 respective, c'est-à-dire pour l'accumulation de charges issues de ladite cellule secondaire 50 via le dispositif d'accumulation 25, typiquement selon l'équation [3] précédente, il est avantageux d'avoir un faible courant $i_\mu$ lorsque la cellule secondaire 50 est du premier type, notamment lorsque le composant mémoire secondaire 52 est une mémoire vive résistive à base d'oxyde, ou OxRAM.

Cet aspect avantageux est par exemple obtenu soit en ayant une faible valeur, typiquement de l'ordre du mV à l'état LRS, pour la tension $V_{TOP}$ respective appliquée au composant mémoire secondaire 52 via la ligne de source SLk correspondante ; soit en utilisant le sélecteur OxRAM conçu pour former/programmer la résistance série ; ou encore soit en ajoutant une résistance série supplémentaire via l'ajout du cascode secondaire 28 comme dans l'exemple de la figure 9.

Avantageusement, la cellule secondaire 50 est du deuxième type, le composant mémoire secondaire 52 comportant alors un transistor à effet de champ utilisant un matériau ferroélectrique, le composant mémoire secondaire 52 étant typiquement un FeMFET ou un FeFET. Ceci présente l'avantage d'une moindre sensibilité au bruit RTN, comparé par exemple au bruit RTN d'une OxRAM, et limite alors le risque de biaiser la variabilité observée sur le courant issu de la cellule primaire 30, pour laquelle le composant mémoire primaire 32 est avantageusement sensible au bruit RTN.

En outre, comme pour une mémoire vive résistive à base d'oxyde, ou OxRAM, la capacité du FeMFET ou FeFET est programmable sur plusieurs niveaux, ce qui permet d'obtenir plusieurs niveaux de valeur pour la quantité secondaire $Q_\mu$, et donc plusieurs niveaux de valeur moyenne de distribution gaussienne.

L'homme du métier observera que le composant mémoire primaire 32 est également programmable sur plusieurs niveaux, notamment lorsque le composant mémoire primaire 32 est du type OxRAM, CBRAM, PCM, MRAM ou encore FTJ, ce qui permet d'obtenir aussi plusieurs niveaux de valeur pour la quantité primaire $Q_\sigma$, et donc plusieurs niveaux de valeur d'écart-type de distribution gaussienne.

L'agencement matriciel des cellules primaire 30 et secondaire 50 au sein du circuit électronique 10 selon l'invention va être à présent décrit en regard des figures 11 à 14.

Dans les exemples des figures 11 à 14, la ou les branches primaires 15 sont agencées en une ou plusieurs colonnes parallèles, chaque branche primaire 15 comportant typiquement plusieurs cellules primaires 30 connectées en parallèle, les cellules primaires 30 correspondant alors à différentes rangées parallèles. De même, la ou les branches secondaires 20 sont agencées en une ou plusieurs colonnes parallèles, chaque branche secondaire 20 comportant typiquement plusieurs cellules secondaires 50 connectées en parallèle, les cellules secondaires 50 correspondant alors à différentes rangées parallèles.

Dans les exemples des figures 11 à 14, les notations de tension utilisées sont celles précédemment décrites pour les figures 1 à 10, avec la précision que la tension $V_{C\_SIGMA}$ correspond à la tension $V_{CASCODE}$ pour la branche sigma, c'est-à-dire pour la branche primaire 15 ; et respectivement que la tension $V_{C\_MU}$ correspond à la tension $V_{CASCODE}$ pour la branche mu, c'est-à-dire pour la branche secondaire 20.

L'homme du métier observera en outre que dans ces exemples des figures 11 à 14, la ou les branches primaires 15 sont alors agencées en parallèle de la ou des branches secondaires 50, chacune de ces branches 30, 50 correspondant à une colonne respective de l'agencement matriciel.

Selon un premier agencement, le circuit électronique 10 comprend N branches primaires 15 et N branches secondaires 20 agencées en parallèle les unes des autres, N étant un nombre entier supérieur ou égal à 2, et le dispositif d'accumulation 25 comporte un unique amplificateur à transimpédance 60 connecté aux branches primaires 15 et secondaires 20, comme représenté sur la figure 11. Dans l'exemple de la figure 11, les branches primaires 15 et secondaires 20 sont disposées en alternance, avec une branche secondaire 20 en parallèle et à la suite d'une branche primaire 15, puis une autre branche primaire 15 en parallèle et à la suite de ladite branche secondaire 20, et ainsi de suite. L'homme du métier comprendra néanmoins que selon ce premier agencement, l'ordre dans lequel les branches primaires 15 et secondaires 20 sont disposées en parallèle est sans importance, et n'a pas d'influence sur le fonctionnement du circuit électronique 10, et en particulier sur l'accumulation de charges via le dispositif d'accumulation 25.

La figure 12 représente une implémentation plus détaillée de l'agencement en parallèle d'une branche primaire 15 et d'une branche secondaire 20 respectives, avec les premières lignes de bit BL1 et source SL1 associées à la branche primaire 15, et les deuxièmes lignes de bit BL2 et source SL2 associées à la branche secondaire 20, et avec alors une cellule primaire 30 suivie d'une cellule secondaire 50 pour chaque rangée respective, chaque rangée étant reliée à une ligne de mot WLi respective. La sélection des lignes de source SLj, SLk, telles que les lignes de source SL1, SL2, et respectivement des lignes de mot WLi, telles que les lignes de source WL1, WL2, est effectuée au moyen de sélecteurs 70 respectifs, également appelés unités logiques de commande.

La figure 13 est similaire à la figure 12, et représente quant à elle une implémentation plus détaillée de l'agencement en parallèle de deux branches primaires 15, avec les premières lignes de bit BL1 et source SL1 associées à une première branche primaire 15, et les deuxièmes lignes de bit BL2 et source SL2 associées à une deuxième branche primaire 15, et avec alors deux cellules primaires 30 successives pour chaque rangée respective, chaque rangée étant reliée à une ligne de mot WLi respective. La sélection des lignes de source SL1, SL2 et de mot WL1, WL2 est également effectuée au moyen de sélecteurs 70 respectifs.

Selon un deuxième agencement, le circuit électronique 10 comprend N branches primaires 15 et N branches secondaires 20 agencées en N paires de branches primaire 15 et secondaire 20, N étant un nombre entier supérieur ou égal à 2, et le dispositif d'accumulation 25 comporte N amplificateurs à transimpédance 60, chacun étant connecté à une paire respective de branches primaire 15 et secondaire 20, comme représenté en partie supérieure de la figure 14.

Ce deuxième agencement présente l'avantage de pouvoir effectuer des accumulations de charges en parallèle pour chaque paire de branches primaire 15 et secondaire 20, et donc de pouvoir générer en parallèle des couples de valeur d'écart-type et de valeur moyenne de distribution gaussienne.

Selon un troisième agencement, le circuit électronique 10 comprend une unique branche primaire 15 et N branches secondaires 20 agencées en parallèle, N étant un nombre entier supérieur ou égal à 2, et le dispositif d'accumulation 25 comporte un unique amplificateur à transimpédance 60 connecté aux branches primaire 15 et secondaires 20, comme représenté en partie inférieure de la figure 14.

Ce troisième agencement présente l'avantage de pouvoir générer plusieurs distributions gaussiennes distinctes, avec plusieurs valeurs moyenne distinctes et une même valeur d'écart-type, tout en nécessitant un nombre restreint de composants électroniques, notamment de branches 15, 20.

**Revendications**

1. Circuit électronique (10) pour la mise en œuvre d'un réseau neuronal bayésien, comprenant :

   - des lignes de bit (BLj) ;
   - des lignes de source (SLj) ;
   - au moins une ligne de mot (WLi) ;
   - au moins une branche primaire (15), la ou chaque branche primaire (15) comportant au moins une cellule primaire (30) connectée entre une ligne de source (SLj) et une ligne de bit (BLj) respectives, la ou chaque cellule primaire (30) incluant un composant mémoire primaire (32) et un commutateur primaire (34) connectés en série, le commutateur primaire (34) ayant une électrode de commande connectée à une ligne de mot (WLi) respective,
   - au moins une branche secondaire (20), la ou chaque branche secondaire (20) comportant au moins une cellule secondaire (50) connectée entre une ligne de source (SLk) et une ligne de bit (BLk) respectives, la ou chaque cellule secondaire (50) incluant un composant mémoire secondaire (52) et un commutateur secondaire (54) connectés entre eux,

   les lignes de source (SLk) et de bit (BLk) associées à la ou chaque branche secondaire (20) étant distinctes des lignes de source (SLj) et de bit (BLj) associées à la ou chaque branche primaire (15),

   - un dispositif d'accumulation (25) connecté aux branches primaire(s) (15) et secondaire(s) (20) et configuré pour accumuler une quantité totale ($Q_{tot}$) de charges électriques issues d'une paire respective de cellules (30, 50), la paire étant formée d'une cellule primaire (30) respective et d'une cellule secondaire (50) respective, la quantité totale ($Q_{tot}$) étant la somme d'une quantité primaire ($Q_\sigma$) de charges issues de ladite cellule primaire (30) et d'une quantité secondaire ($Q_\mu$) de charges issues de ladite cellule secondaire (50), la quantité primaire ($Q_\sigma$) et la quantité secondaire ($Q_\mu$) étant accumulées indépendamment l'une de l'autre.

2. Circuit électronique (10) selon la revendication 1, dans lequel la quantité primaire ($Q_\sigma$) est accumulée au cours de deux phases successives : une phase de charge avec une première valeur de tension ($V_{TOP+}$) appliquée à la ligne de source (SLj) correspondante, et une phase de décharge avec une deuxième valeur de tension ($V_{TOP-}$) appliquée à ladite ligne de source (SLj), la deuxième valeur ($V_{TOP-}$) étant distincte de la première valeur ($V_{TOP+}$).

3. Circuit électronique (10) selon la revendication 1 ou 2, dans lequel la ou chaque branche primaire (15) comporte en outre un convertisseur tension-courant (36) de la cellule primaire (30), le convertisseur tension-courant (36) étant connecté entre un potentiel additionnel ($V_D$) et le dispositif d'accumulation (25), le convertisseur tension-courant (36) ayant une électrode de commande reliée à la cellule primaire (30) via la ligne de bit (BLj) correspondante.

4. Circuit électronique (10) selon les revendications 2 et 3, dans lequel le potentiel additionnel ($V_D$) présente une valeur ($V_{D+}$) supérieure à un potentiel de référence ($V_E$) en entrée du dispositif d'accumulation (25) lors de la phase de charge, et une valeur ($V_{D-}$) inférieure au potentiel de référence ($V_E$) en entrée du dispositif d'accumulation (25) lors de la phase de décharge.

5. Circuit électronique (10) selon la revendication 3 ou 4, dans lequel la ou chaque branche primaire (15) comporte en outre une conductance variable (42), connectée entre un potentiel de référence ($V_{CV}$) et l'électrode de commande du convertisseur tension-courant (36).

6. Circuit électronique (10) selon la revendication 3 ou 4, dans lequel la ou chaque branche primaire (15) comporte en outre un condensateur (38) ayant une borne connectée à l'électrode de commande du convertisseur tension-courant (36) et l'autre borne à un potentiel de référence ($V_{CAP}$) ;
la ou chaque branche primaire (15) comportant de préférence un commutateur auxiliaire (40) connecté entre la borne du condensateur (38) qui connectée à ladite électrode de commande et un potentiel ($V_{OFFSET}$) de pré-charge du condensateur (38).

7. Circuit électronique (10) selon l'une quelconque des revendications précédentes, dans lequel le circuit électronique (10) comporte en outre un cascode, dit cascode primaire (26), connecté entre la ou chaque branche primaire (15) et le dispositif d'accumulation (25).

8. Circuit électronique (10) selon l'une quelconque des revendications précédentes, dans lequel le ou chaque composant mémoire primaire (32) est une mémoire sensible au bruit télégraphique aléatoire (RTN) ;
le ou chaque composant mémoire primaire (32) étant de préférence une mémoire choisie parmi le groupe consistant en : une mémoire résistive à base d'oxyde (OxRAM) ; une mémoire vive à pontage conducteur (CBRAM) ; une mémoire vive à changement de phase (PCM) ; une mémoire vive magnétique (MRAM) ; et une mémoire à empilement ferroélectrique, telle qu'une mémoire ferroélectrique à jonction tunnel (FTJ).

9. Circuit électronique (10) selon l'une quelconque des revendications 1 à 8, dans lequel le ou chaque composant mémoire secondaire (52) est une mémoire choisie parmi le groupe consistant en : une mémoire vive résistive à base d'oxyde (OxRAM) ; une mémoire vive à pontage conducteur (CBRAM) ; une mémoire vive à changement de phase (PCM) ; une mémoire vive magnétique (MRAM) ; et une mémoire à empilement ferroélectrique telle qu'une capacité ferroélectrique (FeRAM) ou une mémoire ferroélectrique à jonction tunnel (FTJ).

10. Circuit électronique (10) selon la revendication 9, dans lequel le composant mémoire secondaire (52) et le commutateur secondaire (54) sont connectés en série entre la ligne de source (SLk) et la ligne de bit (BLk) respectives, le commutateur secondaire (54) ayant une électrode de commande connectée à une ligne de mot (WLj) respective.

11. Circuit électronique (10) selon l'une quelconque des revendications 1 à 8, dans lequel le ou chaque composant mémoire secondaire (52) est un composant choisi parmi le groupe consistant en : un transistor à effet de champ à mémoire ferroélectrique (FeMFET) ; et un transistor à effet de champ ferroélectrique (FeFET).

12. Circuit électronique (10) selon la revendication 11 dans lequel le composant mémoire secondaire (52) est connecté entre la ligne de source (SLk) et la ligne de bit (BLk) respectives, et le commutateur secondaire (54) est connecté entre une ligne de mot (WLj) et une électrode de commande du composant mémoire secondaire (52).

13. Circuit électronique (10) selon l'une quelconque des revendications précédentes, dans lequel le circuit électronique (10) comporte en outre un cascode, dit cascode secondaire (28), connecté entre la ou chaque branche secondaire (20) et le dispositif d'accumulation (25).

14. Circuit électronique (10) selon l'une quelconque des revendications précédentes, dans lequel le dispositif d'accumulation (25) comporte au moins un amplificateur à transimpédance (60).

15. Circuit électronique (10) selon la revendication 14, dans lequel le circuit électronique (10) comprend N branches primaires (15) et N branches secondaires (20) agencées en N paires de branches primaire (15) et secondaire (20), et le dispositif d'accumulation (25) comporte N amplificateurs à transimpédance (60), chacun étant connecté à une paire respective de branches primaire (15) et secondaire (20), N étant un nombre entier supérieur ou égal à 2.

FIG.1

## FIG.2

## FIG.3

FIG.4

FIG.5

FIG.6

FIG.7

FIG.8

SLk ⊓⊔ $V_{TOP}$

52

50

54

$R_{MU}$

WLi

$V_{WL}$ ⊓⊔

$V_{CASCODE\_MU}$ ⊓⊔

iμ

28

$V_{IN}$

BLk

20

## FIG.9

$$\underline{FIG.10}$$

FIG.11

FIG.12

## FIG.13

FIG.14

Europäisches
Patentamt

European
Patent Office

Office européen
des brevets

## RAPPORT DE RECHERCHE EUROPEENNE

Numéro de la demande

EP 25 21 8265

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | EP 4 174 724 B1 (COMMISSARIAT ENERGIE ATOMIQUE [FR]) 11 octobre 2023 (2023-10-11) * le document en entier * ----- | 1-15 | INV. G11C11/54 G06N3/065 |

DOMAINES TECHNIQUES RECHERCHES (IPC)

G11C
G06N

Le présent rapport a été établi pour toutes les revendications

| Lieu de la recherche | Date d'achèvement de la recherche | Examinateur |
|---|---|---|
| La Haye | 31 mars 2026 | Czarik, Damien |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
.......................................................................................
& : membre de la même famille, document correspondant

EPO FORM 1503 03.82 (P04C02)

**EP 4 749 625 A1**

## ANNEXE AU RAPPORT DE RECHERCHE EUROPEENNE
## RELATIF A LA DEMANDE DE BREVET EUROPEEN NO.

EP 25 21 8265

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

31-03-2026

| Document brevet cité au rapport de recherche | | Date de publication | Membre(s) de la famille de brevet(s) | | Date de publication |
|---|---|---|---|---|---|
| EP  4174724 | B1 | 11-10-2023 | EP | 4174724 A1 | 03-05-2023 |
| | | | JP | 2023064732 A | 11-05-2023 |
| | | | US | 2023125074 A1 | 27-04-2023 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 4174724 B1

**Littérature non-brevet citée dans la description**

- **DALGATY et al.** In situ learning using intrinsic memristor variability via Markov chain Monte Carlo sampling. *Nature electronics*, 2021

- **BONNET et al.** Bringing uncertainty quantification to the extreme-edge with memristor-based Bayesian neural networks. *Nature communication*, 2023